# EUROPÄISCHE PATENTSCHRIFT

(11) **EP 1 394 283 B1**
(45) Veröffentlichungstag und Bekanntmachung des Hinweises auf die Patenterteilung: **01.07.2009**
(21) Anmeldenummer: 03018084.8
(22) Anmeldetag: 08.08.2003
(51) Int. Cl.: C23C 4/12, C23C 16/513, C23C 16/455, C23C 16/453

(54) **Verfahren und Vorrichtung zur grossflächigen Beschichtung von Substraten bei Atmosphärendruckbedingungen**
Process and apparatus for coating of large area of substrates under atmospheric pressure
Procédé et dispositif pour le revêtement de substrats de grande surface à pression atmospherique

(30) Priorität: 29.08.2002 DE 10239875
(43) Veröffentlichungstag der Anmeldung: 03.03.2004
(73) Patentinhaber: Fraunhofer-Gesellschaft zur Förderung der angewandten Forschung e.V., 80686 München (DE)
(72) Erfinder: Hopfe, Volkmar, Dr., 01814 Kleingeisshübel (DE); Rogler, Daniela, Dipl.-Ing., 01277 Dresden (DE); Mäder, Gerrit, Dipl.-Ing., 01187 Dresden (DE); Schreuders, Cornelis, Dipl.-Ing., 3602 Thun (CH)
(74) Vertreter: Pfenning, Meinig & Partner GbR

(56) Entgegenhaltungen:
- EP-A- 0 480 581
- DE-A- 19 807 086
- US-A- 5 358 596
- US-B1- 6 406 590

## Beschreibung

Die Erfindung betrifft ein Verfahren und eine Vorrichtung zur großflächigen Beschichtung von Substraten bei Atmosphärendruckbedingungen, wobei mit der erfindungsgemäßen Lösung bei einem Druckbereich, der innerhalb eines Intervalls (max.) 300 Pa) vom jeweiligen Umgebungsatmosphärendruck abweicht, also weit oberhalb der üblicherweise in Vakuumbeschichtungsanlagen herrscht, gearbeitet werden kann.

Die erfindungsgemäße Lösung kann zur Beschichtung von großflächigen Substraten mit hoher Beschichtungsleistung eingesetzt werden. Vorzugsweise ist es möglich, bandförmige Substrate im Durchlaufverfahren mit Spurbreiten bis zu 500 mm zu beschichten. Die Substrate müssen nicht zwingend eine ebene Oberfläche aufweisen und können auch im "Batchbetrieb" auf einer Fläche bis zu 2000 cm² beschichtet werden.

Mit der Erfindung ist es außerdem möglich, die verschiedensten Werkstoffe mit unterschiedlichen Beschichtungen zu versehen. So besteht die Möglichkeit, auch temperatur- und wärmespannungsempfindliche_Substrate wie Gläser, Stähle oder Kunststoffe (Folien) zu beschichten.

In der jüngsten Vergangenheit wurden intensiv Versuche unternommen, um Plasma oder plasmagestützte Beschichtungsverfahren bei deutlich erhöhten Arbeits- und Umgebungsdrücken einsetzen zu können, um den hohen Kostenaufwand bei den etablierten Vakuumbeschichtungsverfahren für die Herstellung dünner homogener Beschichtungen reduzieren zu können.

So ist in DE 198 07 086 eine Lösung beschrieben, bei der mit Elektroden ein elektrisches Feld erzeugt und mit einer durch dieses elektrische Feld geführten ersten Gasphase sowie einer Barriere- oder Koronaentladung ein Plasma erzeugt und dieses Plasma in Richtung auf ein zu beschichtendes Substrat transportiert wird. Diesem Plasmastrahl soll eine zweite Gasphase zugeleitet werden, die einen oder mehrere so genannte Precusoren enthält, mit denen die Ausbildung einer Beschichtung auf einem Substrat erreichbar ist. Bei der vorbeschriebenen Lösung sollen sowohl reine elementare Schichten aber auch die Ausbildung reaktiv gebildeter Oxid- oder Carbidschichten möglich sein.

Mit der in DE 198 07 086 beschriebenen Lösung können aber lediglich kleinflächige Substrate oder Substrate mit relativ kleiner Spurbreite beschichtet werden. Eine ähnliche Lösung ist in DE 199 58 474 A1 offenbart.

Im Gegensatz zu den herkömmlichen Vakuumbeschichtungsverfahren müssen bei Atmosphärendruckbedingungen Plasmen mit höherer Leistungsdichte eingesetzt werden, wobei das Plasma auch mit deutlich höherer Geschwindigkeit in Richtung auf ein zu beschichtendes Substrat gerichtet wird.

Dadurch treten infolge einer unerwünschten, auch nur teilweisen vorzeitigen Partikelbildung Probleme bei der Herstellung homogener, dichter und eine ebene Oberfläche aufweisender Schichten auf. Die unerwünschte Partikelbildung erfolgt bereits infolge chemischer Reaktionen vor Erreichen der Oberfläche des jeweils zu beschichtenden Substrates. Die frühzeitig gebildeten Partikel können dann in körniger Form in die Schicht eingelagert werden, wobei zumindest die Oberflächengüte verschlechtert wird. Durch Extraktion der partikelhaltigen Gasphase vor Erreichen der Substratoberfläche können die gebildeten Partikel aber auch für die Schichtbildung verloren sein, was zumindest zu einer Reduzierung der Beschichtungsrate oder in Extremfällen zu Fehlstellen auf der Oberfläche des zu beschichtenden Substrates führen kann.

In jedem Fall werden aber die stöchiometrischen Verhältnisse für die Ausbildung der Beschichtung unmittelbar auf der Oberfläche des Substrates verschlechtert.

Außerdem sind ein Verfahren und eine Vorrichtung zur Oberflächenbehandlung mit einem Plasma aus US 6,406,590 B1 bekannt. Dabei wird ein Plasma in einem Spalt zwischen einer Elektrodenanordnung und der jeweiligen Oberfläche gebildet und ein Reaktionsgas in den Spalt eingeführt.

Es ist daher Aufgabe der Erfindung Möglichkeiten vorzuschlagen, wie bei Atmosphärendruckbedingungen Substrate großflächig beschichtet und eine vorzeitige unerwünschte Partikelbildung vermieden werden können.

Erfindungsgemäß wird diese Aufgabe mit einem Verfahren gemäß Anspruch 1 und einer Vorrichtung, die die Merkmale des Anspruchs 18 aufweist, gelöst. Vorteilhafte Ausgestaltungsformen und Weiterbildungen der Erfindung können mit den in den untergeordneten Ansprüchen genannten Merkmalen erreicht werden.

Bei der Erfindung wird eine Plasmaquelle, mit der ein großvolumiges Plasma erzeugt werden kann, eingesetzt. Das Plasma kann beispielsweise durch Mikrowellenanregung aber auch mittels eines lang gestreckten zwischen zwei Elektroden ausgebildeten Gleichstrom-Lichtbogens erzeugt werden.

Das großvolumig erzeugte Plasma mit Volumina im Bereich von mindestens 0,25 bis ca. 2 Liter wird dann mit Hilfe eines ersten Gasstromes, der in die Plasmaquelle eingeführt wird, aus dieser ausgetrieben und durch mindestens eine Schlitzdüse oder durch eine Mehrzahl von Düsen mit entsprechend anderen Querschnittsgeometrien auf die zu beschichtende Oberfläche des Substrates, das innerhalb einer z.B. durch ein Atmosphärendruckschleusensystem abgedichteten Reaktionskammer angeordnet ist, gerichtet.

Durch Wahl und Einstellung bestimmter Verfahrensparameter wird gesichert, dass die Schichtausbildung unmittelbar auf der Oberfläche des Substrates durch physiko-chemische Reaktion erfolgt. Für die Schichtausbildung wird mindestens eine Komponente des Precursors, der in mindestens einem zweiten Gasstrom enthalten ist, genutzt. Dieser zweite Gasstrom wird in die Reaktionskammer und in den Einflussbereich des aus der einen oder mehreren Düse(n) ausgetriebenen Plasmas gerichtet.

Dabei kann durch energetische Interaktion und Beeinflussung der Kinematik des zweiten Gasstromes und des ausgetriebenen Plasmas der gewünschte Effekt erreicht werden.

So können die Volumenströme, die Strömungsgeschwindigkeiten und/oder die Strömungsrichtungen des Plasmas und des zweiten Gasstromes gezielt beeinflusst werden.

Ein weiterer Verfahrensparameter der erfindungsgemäß genutzt werden kann, besteht in der Variation des Abstandes der Düsenöffnungen für das ausgetriebene Plasma, wobei optional auch der Abstand der Düsenöffnungen variiert wird, aus denen der zweite Gasstrom in Bezug zum Substrat eingestellt oder gewählt werden kann.

Wichtig ist es außerdem, dass innerhalb der Reaktionskammer ein bestimmter vorgegebener Innendruck eingestellt wird, was mittels einer Abgasabsaugeinrichtung erreicht werden kann, deren Mittel zur Absaugung so geregelt oder gesteuert werden, dass sich ein bestimmter Innendruck einstellt, der geringfügig unter oder über dem Umgebungsdruck liegt oder mit dem Umgebungsdruck übereinstimmt. So können für die Abgasabsaugvorrichtung geeignete Pumpen oder Gebläse, die ansaugseitig mit der Reaktionskammer verbunden sind, eingesetzt werden.

Die erfindungsgemäß einzusetzenden Plasmaquellen können relativ großvolumige Plasmen erzeugen, um jedoch weitaus größere Oberflächenbereiche von Substraten zu beschichten, ist es vorteilhaft, die zu beschichtenden Substrate innerhalb der Reaktionskammer zu bewegen oder, wie bereits angedeutet, bandförmige Substrate durch die Reaktionskammer translatorisch hindurch zu führen.

So können Substrate in Kreisform beschichtet werden, wenn sie um eine Achse gedreht werden. In diesem Fall ist es besonders vorteilhaft, wenn das erzeugte Plasma durch mindestens eine Schlitzdüse, die radial zur Drehachse des Substrates ausgerichtet ist, oder eine Vielzahl von Düsen mit kreisförmigem Durchmesser ausgetrieben wird.

Sollen beispielsweise band- oder großflächige plattenförmige Substrate beschichtet werden, können diese auch translatorisch durch die Reaktionskammer während des Beschichtungsvorganges hindurch geführt werden. Dabei sind zumindest am Ein- und Austritt jeweils ein Atmosphärendruckschleusensystem vorhanden, durch das ein Spülgas zugeführt wird, um die Reaktionskammer gegen die Umgebung abzudichten. Als Spülgase können bevorzugt inerte Gase, die keinen Einfluss auf die physiko-chemischen Reaktionen bei der Schichtbildung ausüben, eingesetzt werden. Wie bereits angesprochen, wird neben dem ersten Gasstrom, der als wesentliche Funktion den Plasmaaustrieb aus der Plasmaquelle erfüllen soll, zumindest ein zweiter Gasstrom in die Reaktionskammer und in den Einflussbereich des Plasmas zugeführt. Der zweite Gasstrom enthält einen Precursor, dessen maximaler Anteil am Gesamtvolumenstrom des zweiten Gasstromes auf 20 Vol.-% begrenzt sein sollte und der restliche überwiegende Anteil am Gesamtvolumenstrom des zweiten Gasstromes erfüllt im Wesentlichen eine strömungskinematische Funktion bei der Ausbildung der Beschichtung auf der Oberfläche des Substrates.

Es besteht aber auch die Möglichkeit, einen zweiten Precursor gemeinsam mit dem ersten Gasstrom zuzuführen.

Insbesondere in den Fällen, bei denen die Beschichtung reaktiv gebildet wird, kann es vorteilhaft sein, neben dem zweiten Gasstrom auch getrennt zu diesem einen dritten bzw. auch einen vierten Gasstrom in die Reaktionskammer zuzuführen, in denen jeweils unterschiedliche Precursoren enthalten sind. Dadurch können vorzeitige chemische Reaktionen vermieden werden und die eigentliche für die Schichtbildung erforderliche chemische Reaktion erfolgt durch die voneinander getrennte Zufuhr, wie erfinderisch gewünscht, erst unmittelbar an der zu beschichtenden Oberfläche des Substrates.

Geeignete Precursoren sind die verschiedensten Kohlenwasserstoffverbindungen, aus denen beispielsweise reine Kohlenstoffschichten oder auch Carbidschichten hergestellt werden können.

Aus metallorganischen Verbindungen können Metallschichten, wiederum Carbidschichten aber auch Metalloxidschichten erhalten werden. Siliciumorganische Verbindungen werden insbesondere für die Ausbildung von SiO₂-Schichten eingesetzt. Als geeignete Precursoren können auch unterschiedliche Halogenide von Titan, Zirkon, Tantal, Chrom, Molybdän, Wolfram, Wismut, Aluminium, Silicium, Germanium, Zinn oder Hydride von Silizium, Germanium oder Bor eingesetzt werden, um in Kombination mit einem oder mehreren weiteren Precursor(en) vorzugsweise Carbide, Nitride, Boride oder Oxide sowie Mischungen dieser Beschichtungen auszubilden.

Es hat sich herausgestellt, dass es günstig ist, entweder das Plasma, einen einen Precursor enthaltenden zweiten, gegebenenfalls auch dritten oder vierten Gasstrom in einem schräg geneigten Winkel auf die zu beschichtende Oberfläche des Substrates zu richten. Es kann durch entsprechende Ausrichtung der für den Austrieb des Plasmas genutzten Düse(n) und/oder der Düsen für die Zufuhr von Precursor enthaltenden Gasströmen, zumindest im Bereich der Düsenöffnungen erreicht werden.

So besteht die Möglichkeit, das Plasma über eine Düse, deren Längsachse zumindest nahezu orthogonal zur zu beschichtenden Oberfläche des Substrates ausgerichtet ist, auszutreiben und den zweiten Gasstrom über zumindest eine benachbart zu der/den Düse(n) für das Plasma angeordnete schräg geneigt ausgerichtete Düse zuzuführen, so dass sich die Volumenströme des Plasmas und des Gasstromes kreuzen.

So kann ein solcher Precursor enthaltender Gasstrom über zwei sich diametral an einer Düse für Plasma gegenüberliegenden Düsen, einer Ringanordnung mehrerer Düsen, aber auch über eine eine solche Düse umschließende Ringdüse mit konisch ausgebildetem Ringspalt zugeführt werden.

Es besteht aber auch die Möglichkeit, das Plasma aus der Plasmaquelle aus zwei in einem Abstand zueinander angeordneten Düsen in einem schräg aufeinander zu geneigten Winkel auszutreiben, so dass sich die beiden Plasmastrahlen innerhalb der Reaktionskammer schneiden. Zwischen diesen beiden Düsen für das Plasma kann dann zumindest eine Düse für den Precursor enthaltenden zweiten Gasstrom angeordnet sein, so dass dieser in den Einflussbereich des Plasmas an dem jeweiligen Schnittpunkt gelangen kann und dieser Gasstrom intensiv vom jeweiligen Plasma beeinflusst wird.

Vorteilhaft kann es auch sein, den zweiten Precursor enthaltenden zweiten Gasstrom mit deutlich höherer Strömungsgeschwindigkeit, zumindest jedoch der zweifachen Strömungsgeschwindigkeit des Plasmas in die Reaktionskammer zu richten. Dadurch können strömungskinetische Effekte erreicht werden, die sich vorteilhaft auf die Ausbildung der Beschichtung auf der Oberfläche des Substrates auswirken. Insbesondere wirkt sich eine erhöhte Strömungsgeschwindigkeit des zweiten Gasstromes vorteilhaft aus, wenn das zu beschichtende Substrat translatorisch durch die Reaktionskammer transportiert wird, da so der unerwünschte Einfluss einer unmittelbar auf der Oberfläche des zu beschichtenden Substrates vorhandenen gasförmigen Barriereschicht beseitigt, zumindest jedoch erheblich reduziert werden kann.

Ein weiterer Parameter, mit dem man die Schichtausbildung auf der Oberfläche des Substrates beeinflussen kann, ist der Abstand der Düsenöffnungen für das Plasma und/oder der Düsenöffnungen für den Precursor enthaltenden zweiten Gasstrom, sowohl zueinander, wie auch zu der zu beschichtenden Oberfläche des Substrates. Letzteres kann in einer erfindungsgemäßen Vorrichtung relativ einfach variiert werden, in dem beispielsweise die eingesetzte Plasmaquelle mit den Düsen und Düsenöffnungen in Bezug zum jeweils zu beschichtenden Substrat bewegt und so der Abstand eingestellt wird.

Mit einer erfindungsgemäßen Vorrichtung kann aber auch neben der eigentlichen Beschichtung von Oberflächen von Substraten eine Oberflächenmodifizierung oder eine nachträgliche Beeinflussung der bereits ausgebildeten Schicht erreicht werden. So kann die Oberfläche gereinigt werden, es können auch unerwünschte Oberflächenablagerungen abgetragen, eine thermische, strahlungsinduzierte und/oder chemische Beeinflussung erfolgen.

Im einfachsten Fall kann zeit- oder bereichsweise die zu beschichtende Oberfläche des Substrates ausschließlich mit dem Plasma aus der Plasmaquelle behandelt werden, wodurch zumindest eine thermische Beeinflussung der Oberfläche erreichbar ist (z.B. eine Änderung der Oberflächenenergie und somit eine Verbesserung des Benetzungsverhaltens). Mit dem reinen Plasma kann eine Oberflächenreinigung bzw. auch ein Halten der erhöhten Temperatur einer bereits auf einer Substratoberfläche ausgebildeten Schicht erreicht werden. Im letzteren Fall kann so Einfluss auf die Gefüge- bzw. Kristallgitterausbildung innerhalb der Schicht genommen werden.

Es können aber auch durch zusätzliche Zufuhr an sich bekannter Ätzgase eine Oberflächenmodfizierung durch Trockenätzen durchgeführt werden. Solche Ätzgase können mit dem ersten Gasstrom, gemeinsam mit dem Plasma durch die Reaktionskammer auf die Oberfläche des Substrates gerichtet werden. Es besteht aber auch die Möglichkeit, die Ätzgase über gesonderte Düsen unmittelbar in die Reaktionskammer und den Einflussbereich des ausgetriebenen Plasmas zuzuführen.

So besteht die Möglichkeit im Durchlaufbetrieb, bei dem ein Substrat durch die Reaktionskammer hindurch geführt wird, mehrere Verfahrensschritte nacheinander an jeweils bestimmten Oberflächenbereiche des Substrates durchzuführen.

So können beispielsweise eine oder mehrere Düsen für Plasma in Richtung auf den Eintritt für das Substrat angeordnet werden und im Anschluss daran in einem Bereich eine Kombination von Düsen für Plasma mit Düsen für den Precursor enthaltenden zweiten Gasstrom vorzusehen, an den sich wiederum ein dritter Bereich anschließt, in dem ausschließlich Düsen für Plasma angeordnet sind. So kann an dem durch die Reaktionskammer geführten Substrat zuerst eine Oberflächenmodifizierung und/oder Oberflächenreinigung, dann die Ausbildung der Beschichtung und im Nachgang dazu die thermische Beeinflussung der bereits ausgebildeten Schicht erreicht werden. Im einfachsten Fall können die vor- und nachgelagerten Plasmagasströme gleichzeitig die Funktion der Abdichtung der Reaktionskammer übernehmen und damit zu einer Verminderung der anderweitig notwendigen Spülgasströme beitragen.

Die mit dem zumindest zweiten Gasstrom zugeführten Precursoren sollten besonders vorteilhaft gasförmig sein. Es besteht aber auch die Möglichkeit, flüssige, beispielsweise Aerosole, Precursoren und auch aus feinen Partikeln gebildete Precursoren einzusetzen. Diese Precursoren können reine Elemente oder chemische Verbindungen sein, wobei in der Regel eine chemische Verbindung innerhalb der Reaktionskammer aufgebrochen oder reduziert wird.

In jedem Fall ist es jedoch besonders vorteilhaft, dass der eine oder auch mehrere eingesetzte Precursor(en) zumindest innerhalb der Reaktionskammer in Gasphasenform vorliegt, was durch einen entsprechenden Energieeintrag, zum größten Teil unter Ausnutzung der Plasmaenergie und/oder Abwärme der Plasmaquelle erreicht werden kann. So kann mit nahezu absoluter Sicherheit gewährleistet werden, dass die unerwünschte Partikelbildung vor der Ausbildung der eigentlichen Beschichtung vermieden werden kann.

Wie bereits angedeutet, können die großvolumigen Plasmen einmal mit einer Mikrowellenplasmaquelle und zum anderen mit einer Lichtbogenplasmaquelle erzeugt werden.

So ist eine geeignete Mikrowellenplasmaquelle in WO 98/59359 beschrieben, auf deren Offenbarungsgehalt hier Bezug genommen werden soll. Diese weist eine zylinderförmige Plasmakammer auf, in die von außen rotationssymmetrisch die Mikrowellen eingekoppelt werden, so dass das großvolumige Plasma nahezu im Zentrum der Plasmakammer ausgebildet wird. An einer Stirnfläche der Plasmakammer ist zumindest eine Düsenöffnung für Plasma, durch die das Plasma in die Reaktionskammer ausgetrieben werden kann, vorhanden. In diesem Fall sollte die eine Düse als relativ lange Schlitzdüse ausgebildet sein.

Es besteht aber auch die Möglichkeit, Düsen mit anderen Querschnittsgeometrien oder auch mehrere solcher Schlitzdüsen innerhalb der Stirnfläche der Plasmakammer auszubilden, wobei die Anzahl, die Anordnung und die freien Querschnitte der Düsen so gewählt werden können, dass vom aus der Plasmakammer ausgetriebenes, durch die Reaktionskammer auf die Oberfläche des zu beschichtenden Substrates gerichtetes Plasma einen großen Oberflächenbereich des Substrates beeinflussen kann.

So können beispielsweise Düsenöffnungen in mehreren Reihen angeordnet werden und bevorzugt eine versetzte Anordnung von Düsenöffnungen in benachbarten Reihen gewählt werden.

Es besteht aber auch die Möglichkeit, einen oder mehrere Precursoren mit einem zweiten und gegebenenfalls dritten oder vierten Gasstrom über Düsen, deren Düsenöffnungen ebenfalls an bzw. in dieser Stirnfläche der Plasmakammer angeordnet sind, in die Reaktionskammer einzuführen, wobei so eine vorab Aufheizung erreicht werden kann.

Die Zufuhr des ersten Gasstromes mit dem das Plasma aus der Plasmakammer in die Reaktionskammer ausgetrieben werden soll, erfolgt bevorzugt von einer der beiden Stirnseiten der Plasmakammer, so dass eine Gasströmung entlang und nahezu parallel zur inneren Mantelfläche der zylindrischen Plasmakammer, in diesem Bereich das Plasma vollständig umschließend, erreicht wird. So kann der erste Gasstrom durch eine umlaufende Ringdüse an der jeweiligen Stirnseite der Plasmakammer oder eine Kreisringanordnung einer Mehrzahl solcher Düsen für die Zufuhr des ersten Gasstromes in die Plasmakammer eingeführt werden. Eine solche Gasströmung entlang und parallel zur inneren Mantelfläche der Plasmakammer ist sowohl strömungstechnisch für den Austrieb von Plasma aus der Plasmakammer, wie auch für die Kühlung des zylinderförmigen Einkoppelfensters der Plasmaquelle sehr vorteilhaft. Weiterhin kann bei dieser Einspeisungsvariante der Energiegehalt/Aktivierung des Plasmas erhöht oder die für die Erzeugung eines eine ausreichende Energiedichte aufweisenden Plasmas erforderliche Energie reduziert werden.

Es hat sich besonders vorteilhaft herausgestellt, dass eine Zufuhr des ersten Gasstromes für den Austrieb aus der Plasmakammer von der Stirnseite der Plasmakammer, an der die Düse(n) mit den Düsenöffnungen für das Plasma, angeordnet sind, erfolgt.

Die Stirnflächen der Plasmakammer sollten aus einem geeigneten Metall bestehen, mit einem solchen Metall beschichtet sein oder zumindest ein solches Metall enthalten.

Alternativ kann aber auch eine Plasmaquelle eingesetzt werden, bei der das Plasma mittels eines zwischen zwei parallel zueinander ausgerichteten Elektroden gezündeten Lichtbogens erzeugt wird. Eine besonders geeignete Ausführungsform einer solchen Plasmaquelle ist in EP 08 51 720 B1 beschrieben, auf deren Offenbarungsgehalt vollumfänglich Bezug genommen wird.

Eine solche Plasmaquelle kann in gewissen Grenzen skaliert und dementsprechend durch eine Variation der Länge des Lichtbogens, eine Einflussnahme auf die Länge des erzeugten Plasmas und dementsprechend auch das Plasmavolumen sowie die mit ausgetriebenem Plasma beeinflussbare Größe der Oberfläche des Substrates genommen werden.

Das mit dem Lichtbogen erzeugte Plasma kann über eine Schlitzdüse ausgetrieben werden, so dass sich entsprechend der Länge der Schlitzdüse eine entsprechende Fläche bei Bewegung eines Substrates innerhalb der Reaktionskammer beschichten lässt.

Die Düsenöffnung der Schlitzdüse sollte möglichst in Düsenöffnungsrichtung konisch verjüngend ausgebildet sein.

Der zweite einen Precursor enthaltende Gasstrom kann dann über eine diese Schlitzdüse für das Plasma umschließende Ringdüse oder auch über eine Mehrzahl von um die Schlitzdüse angeordneten Düsen mit entsprechenden Düsenöffnungen in die Reaktionskammer zugeführt werden.

Zur Verbesserung der Homogenität des aus einer solchen Plasmaquelle ausgetriebenen Plasmas kann aber auch mit einer Reihenanordnung mehrerer Düsenöffnungen in Form einer Loch- oder Schlitzblende, die die Schlitzdüse einer solchen Plasmaquelle abdeckt, eingesetzt werden.

Mit der erfindungsgemäß einzusetzenden Abgasabsaugung können zum einen für die Schichtbildung unerwünschte Reaktionsprodukte, zusätzliche im Plasma und im zweiten Gasstrom enthaltene Komponenten, die für die Schichtbildung nicht benötigt werden, aus der Reaktionskammer entfernt und zum anderen innerhalb der Reaktionskammer ein bestimmter für die Schichtbildung besonders günstiger Innendruck eingestellt werden. Dabei ist insbesondere zur Vermeidung der unerwünschten Partikelbildung letztgenannter Aspekt von besonderer Bedeutung.

Hierfür sollte die Abgasabsaugung die Reaktionskammer allseitig umschließen, so dass innerhalb der Reaktionskammer besonders an den verschiedenen Oberflächenbereichen des zu beschichtenden Substrates nahezu gleiche Verhältnisse eingehalten werden können.

In ähnlicher Form sollte auch die Spülgaszuführung des Atmosphärendruckschleusensystems ausgebildet sein, wobei es sich bei einem Durchlaufbetrieb, bei dem die zu beschichtenden Substrate durch die Reaktionskammer hindurch bewegt werden, ein Atmosphärendruckschleusensystem, das lediglich am Ein- und Austritt für Substrate angeordnet und wirksam ist, ausreichen kann.

Nachfolgend soll die Erfindung beispielhaft näher beschrieben werden.

Dabei zeigen:
- Figur 1: in schematischer Form ein Beispiel einer erfindungsgemäßen Vorrichtung;
- Figur 2: ein zweites Beispiel einer erfindungsgemäßen Vorrichtung mit modifizierter Zuführung für einen Precursor enthaltenden Gasstrom;
- Figur 3: ein drittes Beispiel einer erfindungsgemäßen Vorrichtung mit Mehrfachzuführung;
- Figur 4: in schematischer Form eine geeignete Mikrowellenplasmaquelle;
- Figur 5: ein Beispiel mit zwei aufeinander zu gerichteten Plasmastrahlen;
- Figur 6: ein Beispiel einer Vorrichtung mit einer Lichtbogen-Plasmaquelle;
- Figur 7: eine Draufsicht auf eine Mikrowellenplasmaquelle mit mehreren Düsenöffnungen in Kreisringanordnung;
- Figur 8: eine Draufsicht auf eine Mikrowellenplasmaquelle mit einer mehrreihigen Anordnung von Düsenöffnungen;
- Figur 9: in schematischer Form ein Strömungsprofil innerhalb einer Mikrowellenplasmaquelle;
- Figur 10: in schematischer Darstellung ein Strömungsprofil eines von einem ersten Gasstrom ausgetriebenen Plasmas, in das ein zweiter Gasstrom gemeinsam mit dem Plasma in eine Reaktionskammer eingeführt und auf das Substrat gerichtet wird.
- Figur 11: in schematischer Darstellung die laterale Konzentrationsverteilung des Precursors über der in Fig. 2 und Fig. 10 dargestellten Düsenanordnung.
- Figur 12: ein Tiefenprofil der optischen Dichte in einer SiO2 Schicht auf Glas- und Edelstahlsubstraten.
- Figur 13: ein optisches Emissionsspektrum des aus der Mikrowellen-Plasmakammer ausgetriebenen Plasmas nach Vermischung mit einem Precursor zur Abscheidung von SiO2-Schichten, in Substratnähe gemessen.

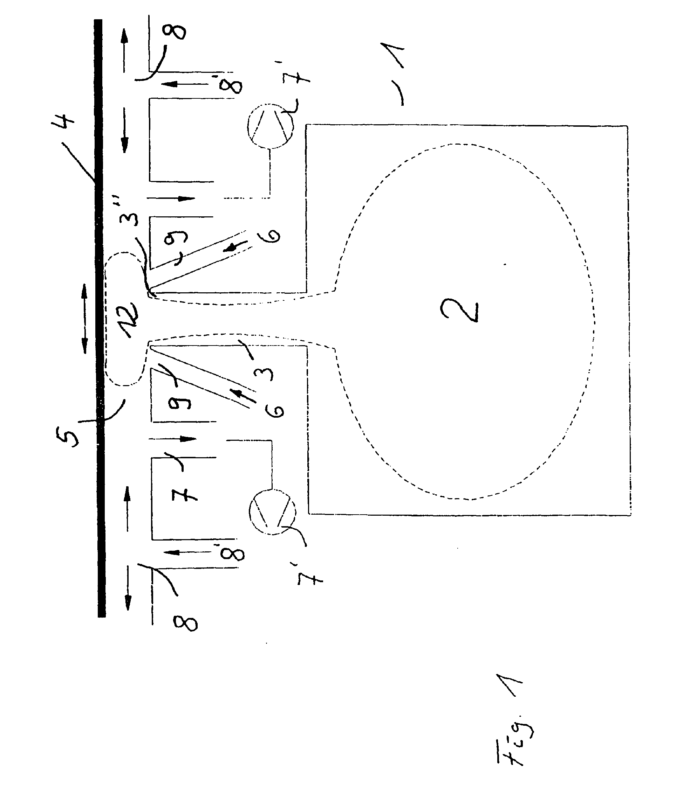

In Figur 1 ist in schematischer Form ein Beispiel einer erfindungsgemäßen Vorrichtung für die großflächige Beschichtung von Substraten 4 beschrieben.

Bei dem hier gezeigten Beispiel ist eine Plasmaquelle 1 unterhalb eines großflächig zu beschichtenden Substrates 4 angeordnet, in der ein großvolumiges Plasma 2 erzeugt werden kann. Eine solche Anordnung ist besonders zu bevorzugen, wenn eine Mikrowellenplasmaquelle, als Plasmaquelle 1 eingesetzt wird.

In Figur 1 ist auf die Darstellung der Zufuhr des ersten Gasstromes 10 in die Plasmaquelle 1 verzichtet worden.

Mit diesem ersten Gasstrom 10 wird das Plasma durch mindestens eine Düse 3 aus der Plasmaquelle 1 ausgetrieben und gelangt über die Düsenöffnung 3'' in eine Reaktionskammer 5, durch die das zu beschichtende Substrat 4 translatorisch bewegt werden kann.

Wie aus Figur 1 ersichtlich, kann dabei das zu beschichtende Substrat 4 eine Kammerwand der Reaktionskammer 5 bilden, was jedoch nicht zwingend erforderlich ist.

Um die Düse 3 ist eine Mehrzahl von Düsen 9, deren Längsachsen in einem Winkel schräg geneigt sind, vorhanden, deren Düsenöffnungen um die Düsenöffnung 3", durch die das Plasma 12 ausgetrieben wird, angeordnet sind. Durch die Düsen 9 wird der zweite mindestens einen Precursor enthaltende Gasstrom 6 in die Reaktionskammer 5 und in den Einflussbereich des Plasmas 12 zugeführt, dabei energetisch angeregt und für die eigentliche Ausbildung der Schicht auf der Oberfläche des Substrates 4, der jeweilige mindestens eine Precursor vorbereitet, so dass die eigentliche Schichtausbildung und Festphasenbildung unmittelbar auf der Oberfläche des Substrates 4 erfolgen kann.

Die Reaktionskammer 5 ist von einer hier ringförmigen Abgasabsaugung 7 umgeben, so dass mittels bevorzugt mehrerer Pumpen oder Gebläse 7' Abgasbestandteile aus der Reaktionskammer 5 entfernt und ein bestimmter Innendruck innerhalb der Reaktionskammer 5 eingestellt werden kann. Die an der Abgasabsaugung 7 eingesetzten Pumpen oder Gebläse 7' können entsprechend gesteuert oder geregelt werden.

Zumindest am Ein- und Austritt des translatorisch bewegten Substrates 4, besser jedoch die Reaktionskammer 5 und die Abgasabsaugung 7 voll umschließend, ist ein Atmosphärendruckschleusensystem 8 vorhanden, bei dem über entsprechende Düsen ein Spülgas 8', das, wie im allgemeinen Teil der Beschreibung bereits angesprochen, bevorzugt für den jeweiligen Beschichtungsprozess inert ist, zugeführt wird.

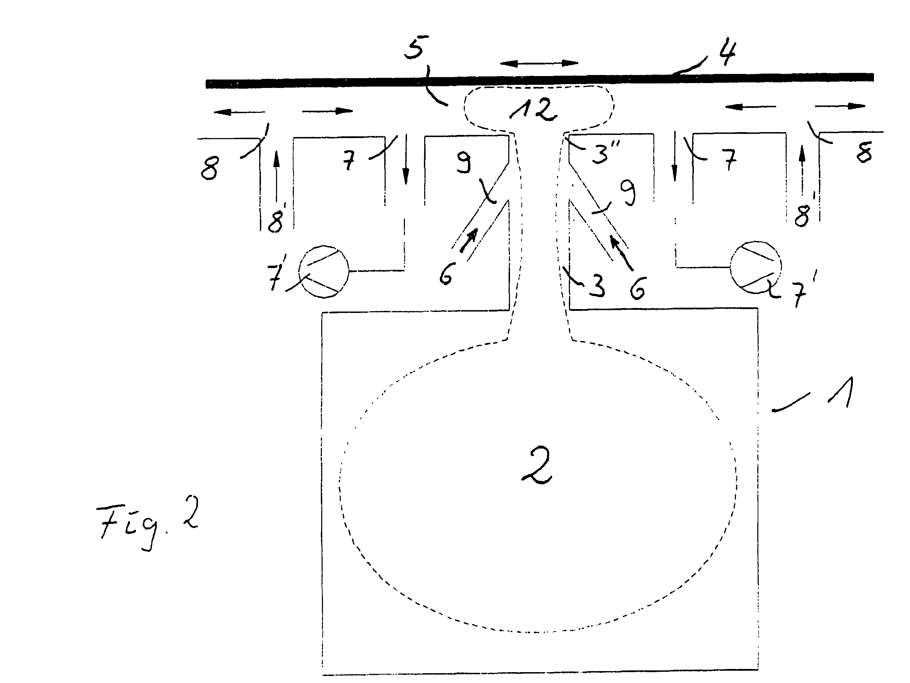

Das in Figur 2 gezeigte Beispiel einer erfindungsgemäßen Vorrichtung entspricht in wesentlichen Punkten dem, wie es in Figur 1 entnommen werden kann.

Dabei wurden lediglich die Anordnung der Düsenöffnungen der Düsen 9, durch die der Precursor enthaltende zweite Gasstrom 6 zugeführt wird, verändert. Bei diesem Beispiel sind die Düsenöffnungen der Düsen 9 in einem größeren Abstand vom zu beschichtenden Substrat 4 und innerhalb der Düse 3 für Plasma, also vor der Düsenöffnung 3'' angeordnet, so dass der zweite Gasstrom 6 früher in den Einflussbereich des Plasmas gelangt und frühzeitiger aktiviert wird. Weiterhin wird die Gleichmäßigkeit der Vermischung günstig gestaltet.

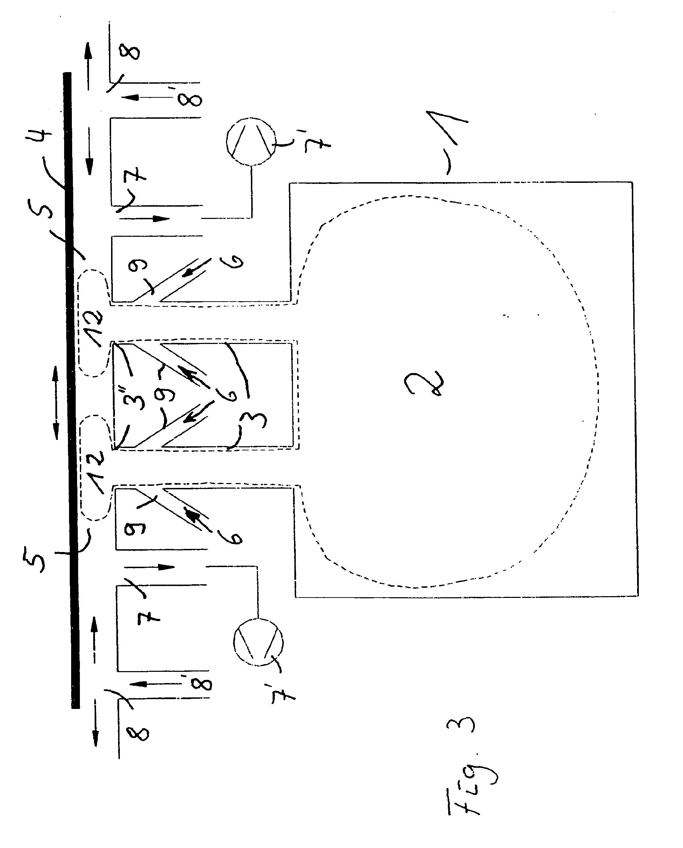

In Figur 3 ist ein Beispiel einer erfindungsgemäßen Vorrichtung gezeigt, bei der mehrere Düsen 3 für Plasma mit jeweils zugeordneten Düsen 9 für mindestens einen zweiten Gasstrom 6 vorhanden sind.

Selbstverständlich besteht auch hier die Möglichkeit, die Düsenöffnungen der Düsen 9 analog zum Beispiel nach Figur 1 anzuordnen.

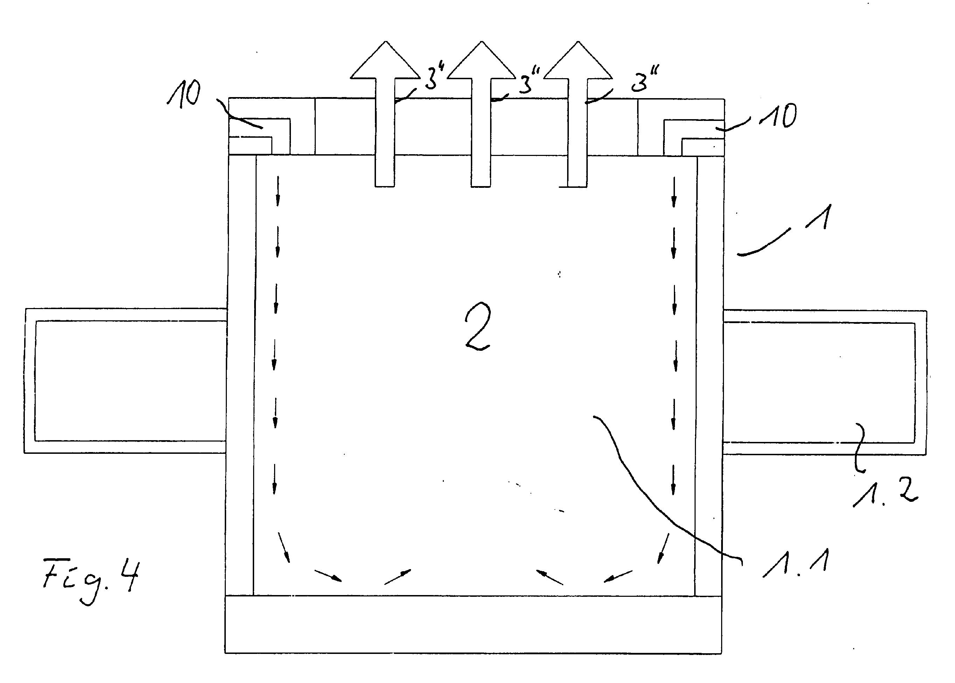

Mit Figur 4 soll schematisch eine Mikrowellenplasmaquelle 1 in einer Schnittdarstellung gezeigt werden.

Dabei wird in einer besonders bevorzugten Ausführungsform der erste Gasstrom 10 über eine umlaufende Ringdüse, ausgehend von der nach oben weisenden Stirnseite der zylinderförmigen Plasmakammer 1.1 zugeführt.

Die Ringdüse ist dabei am äußeren Rand der zylindrischen Mantelfläche angeordnet, so dass der erste Gasstrom 10 entlang der inneren Mantelfläche der Plasmakammer 1.1, das generierte großvolumige Plasma 2 allseitig umschließend durch die Plasmakammer 1.1 geführt, an der unteren Stirnfläche der Plasmakammer 1.1 für den Austrieb von Plasma über mindestens eine in Figur 4 schematisch angedeutete Düsenöffnung 3" durch die obere Stirnfläche der Plasmakammer 1.1 erst umgelenkt und dann ausgetrieben wird.

Es besteht aber auch die Möglichkeit, eine solche Ringdüse bzw. eine entsprechende Kreisringanordnung einer Vielzahl von solchen Düsen in einem Abstand von der oberen Stirnfläche anzuordnen oder die Zufuhr des ersten Gasstromes 10 durch die untere Stirnfläche der Plasmakammer 1.1 entlang der inneren Mantelfläche der zylinderförmigen Plasmakammer 1.1 zu realisieren.

In jedem Fall sollte aber der erste Gasstrom 10 in der Plasmakammer 1.1 zwischen der inneren Mantelfläche der Plasmakammer 1.1 und dem großvolumig erzeugten Plasma 2 innerhalb der Plasmakammer 1.1 geführt werden.

Die zylinderförmige Plasmakammer 1.1 ist in einem Teilbereich von einem schematisch angedeuteten Mikrowellenresonator 1.2 umschlossen.

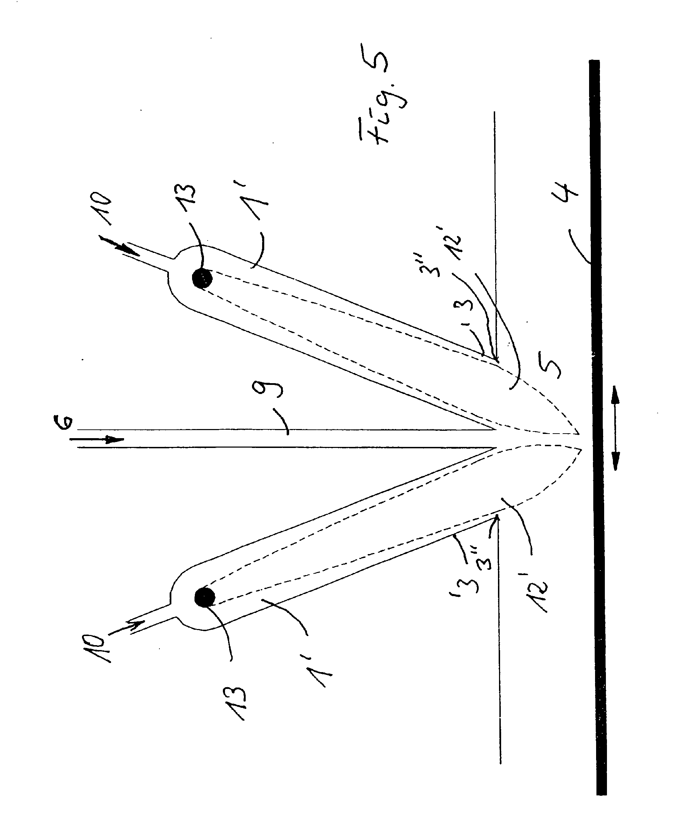

Mit Figur 5 soll eine Möglichkeit der Zufuhr von Plasma und einem einen Precursor enthaltenden zweiten Gasstrom 6 in die Reaktionskammer 5 angedeutet werden. Dabei sind bei diesem Beispiel zwei Plasmaquellen 1 eingesetzt worden, deren ausgetriebene Plasmastrahlen 12' in einem schräg geneigten Winkel aufeinander zu gerichtet sind. Zwischen diesen Plasmaquellen 1 und demzufolge auch den ausgetriebenen Plasmastrahlen 12' ist mindestens eine Düse 9, über die der Precursor enthaltende zweite Gasstrom 6 in die Reaktionskammer 5 zugeführt wird, vorhanden. Dabei trifft der zweite Gasstrom 6 unmittelbar auf die sich schneidenden Plasmastrahlen 12', bevor er die zu beschichtende Oberfläche des Substrates 4 erreicht.

In analoger Form können aber auch zwei in einem schräg geneigten Winkel aufeinander zu gerichtete Plasmastrahlen 12' aus einer gemeinsamen Plasmaquelle 1 bzw. 1' ausgetrieben werden, wenn das auszutreibende Plasma 12 durch entsprechend ausgerichtete Düsen 3 in die Reaktionskammer 5 geführt werden und zwischen den Düsenöffnungen 3" zumindest eine Düse 9 für einen zweiten Gasstrom 6 angeordnet ist.

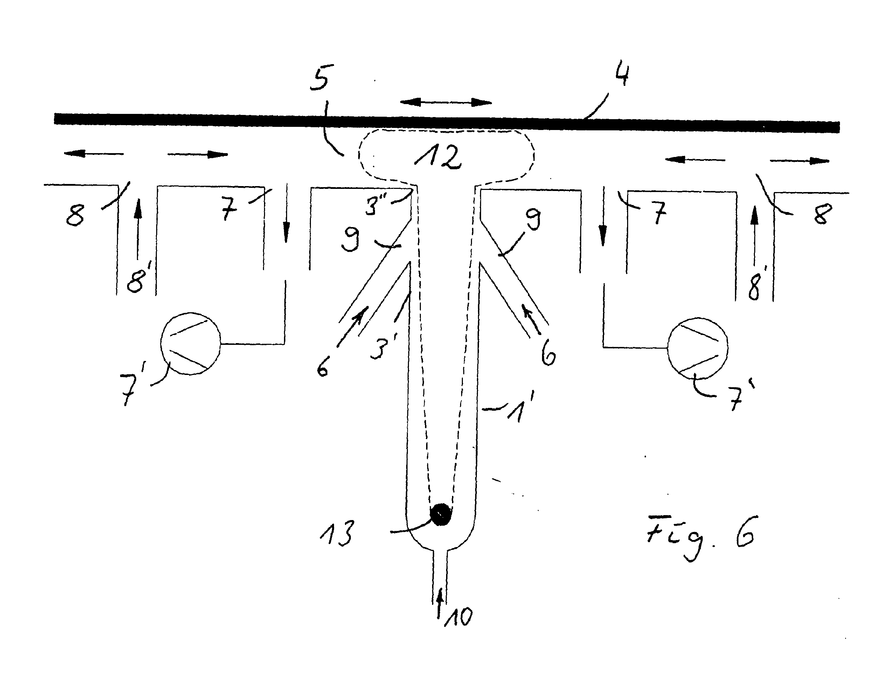

Mit Figur 6 soll ein Beispiel einer erfindungsgemäßen Vorrichtung gezeigt werden, bei der eine Lichtbogen-Plasmaquelle 1' eingesetzt worden ist.

Die Plasmaquelle 1' sollte im Gegensatz zur Darstellung oberhalb der zu beschichtenden Oberfläche des Substrates 4 angeordnet sein. Der erste Gasstrom 10 wird senkrecht in die in Zeichnungsebene lang gestreckte Plasmaquelle 1' zugeführt und treibt ein mit zwei entlang einer Achse ausgerichteten Elektroden 13 ausgebildeten lang gestreckten Lichtbogens erzeugtes Plasma aus der Plasmaquelle 1' durch die Düsenöffnung 3", die bevorzugt als sich in Richtung Reaktionskammer 5 konisch verjüngende Schlitzdüse ausgebildet ist, in die Reaktionskammer 5 aus.

Auch bei einer Lichtbogen-Plasmaquelle 1' kann der zweite Gasstrom 6 über sich gegenüberliegend angeordnete Düsen 9 in den Einflussbereich des Plasmas 12 und in die Reaktionskammer 5 zugeführt werden.

Wie in Figur 6 dargestellt, kann der zweite Gasstrom 6 bereits innerhalb der Plasmaquelle 1' in den Einflussbereich des auszutreibenden Plasmas 12 zugeführt werden. In nicht dargestellter Form besteht aber auch die Möglichkeit, die Austrittsöffnungen der Düsen 9 weiter in Richtung Substrat 4 anzuordnen, also eine Zufuhr des zweiten Gasstromes 6 unmittelbar in die Reaktionskammer 5 und erst dort in den Einflussbereich des Plasmas 12 zu erreichen.

Die übrigen Komponenten und Elemente der in Figur 6 dargestellten Vorrichtung, entsprechen im Wesentlichen den bei den vorab beschriebenen Beispielen, so dass eine weiterführende Erläuterung hierzu, an dieser Stelle unterbleiben kann.

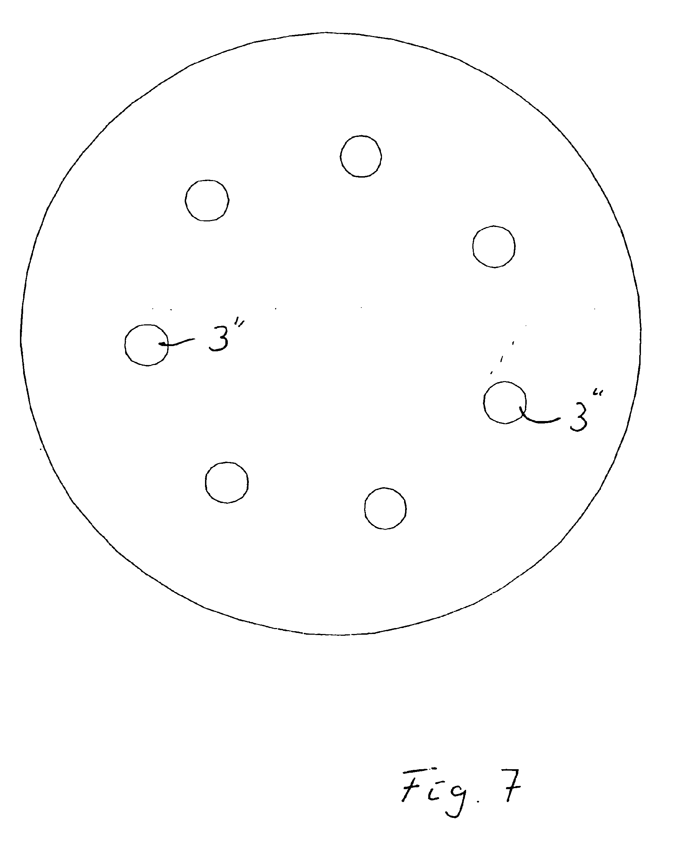

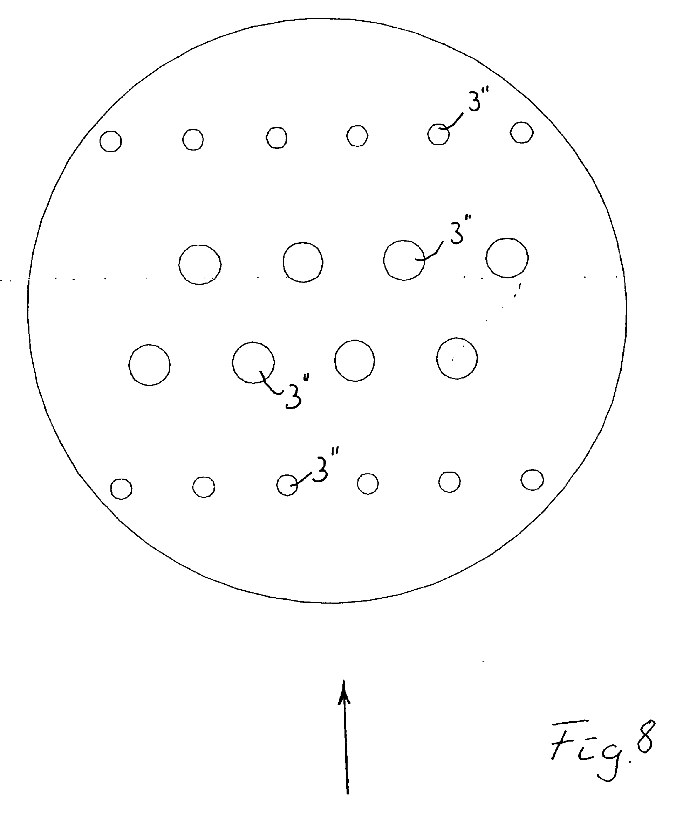

Mit den in den Figuren 7 und 8 gezeigten Ausführungsformen für Mikrowellenplasmaquellen 1, sollen Möglichkeiten für die Anordnung und Ausbildungen von Düsenöffnungen 3" verdeutlicht werden.

Das in der Mikrowellenplasmaquelle 1 erzeugte Plasma kann mittels des ersten Gasstromes, der in die Mikrowellenplasmaquelle 1 eingeführt wird, durch die an einer Stirnfläche ausgebildeten Düsen über die Düsenöffnungen 3" in die Reaktionskammer 5 ausgetrieben werden.

Bei entsprechender Dimensionierung der freien Querschnitte der Düsenöffnungen 3'', der Anzahl und der Abstände zwischen den Düsenöffnungen 3" zueinander und zur zu beschichtenden Oberfläche eines Substrates 4 kann ein relativ homogener Plasmastrom, in dem bereits mindestens ein zur Schichtbildung ausnutzbarer Precursor enthalten ist, auf die zu beschichtende Oberfläche gerichtet werden.

So ist in Figur 7 eine kreisringförmige Anordnung von mehreren Düsenöffnungen 3" gezeigt, über die das Plasma und der zweite einen Precursor enthaltende Gasstrom in die Reaktionskammer 5 gelangen kann, dargestellt. Eine solche Ausbildung bietet sich immer dann an, wenn beispielsweise ein Substrat 4 nicht durch eine Reaktionskammer 5 hindurch bewegt wird.

Das Beispiel, wie es in Figur 8 gezeigt ist, soll eine Anordnung von Düsenöffnungen 3'' an einer Stirnfläche einer Mikrowellenplasmaquelle 1 darstellen, das bevorzugt bei translatorisch durch eine Reaktionskammer 5 hindurch geführten Substraten 4 einsetzbar ist. Die translatorische Bewegung eines hier nicht dargestellten Substrates 4 ist mit dem entsprechenden Pfeil angedeutet.

Hierbei sind Düsenöffnungen 3" in mehreren Reihen hintereinander in Bewegungsrichtung des Substrates 4 angeordnet.

So ist die in Bewegungsrichtung des Substrates 4 angeordnete vordere Reihe von Düsenöffnungen 3" und die in Bewegungsrichtung letzte Reihe von Düsenöffnungen 3'' mit deutlich kleineren freien Querschnitten der Düsenöffnungen 3" vorgesehen.

Durch diese Düsenöffnungen 3" kann ausschließlich Plasma in die Reaktionskammer 5 auf die Oberfläche des Substrates 4 gerichtet werden. Dabei kann das durch die vorderste Reihe von Düsenöffnungen 3'' auf die Oberfläche des Substrates 4 gerichtete Plasma, die Oberfläche des Substrates 4, wie im allgemeinen Teil bereits beschrieben, entsprechend modifizieren oder reinigen.

Die beiden mittleren Reihen von Düsenöffnungen 3", mit deutlich größeren freien Querschnitten führen Plasma gemeinsam mit dem zweiten Gasstrom 6 für die Ausbildung der Beschichtung auf der Oberfläche des Substrates 4 in die Reaktionskammer 5 ein.

Um eine homogene möglichst gleichmäßige Schicht auszubilden, sollten diese Düsenöffnungen 3" in benachbarten Reihen in versetzter Anordnung ausgebildet sein.

Die in Bewegungsrichtung des Substrates 4 hinterste Reihe von Düsenöffnungen 3" führt wiederum ausschließlich Plasma in die Reaktionskammer 5 und durch die Energie, insbesondere deren Wärme kann die auf der Oberfläche des Substrates 4 bereits vorab ausgebildete Schicht, beispielsweise bezüglich einer günstigen Kristall- oder Gefügeausbildung beeinflusst werden.

In nicht dargestellter Form kann eine ein- oder auch mehrreihige Anordnung von Düsenöffnungen 3" auch am Austritt des Plasmas aus einer Lichtbogenplasmaquelle 1' eingesetzt werden.

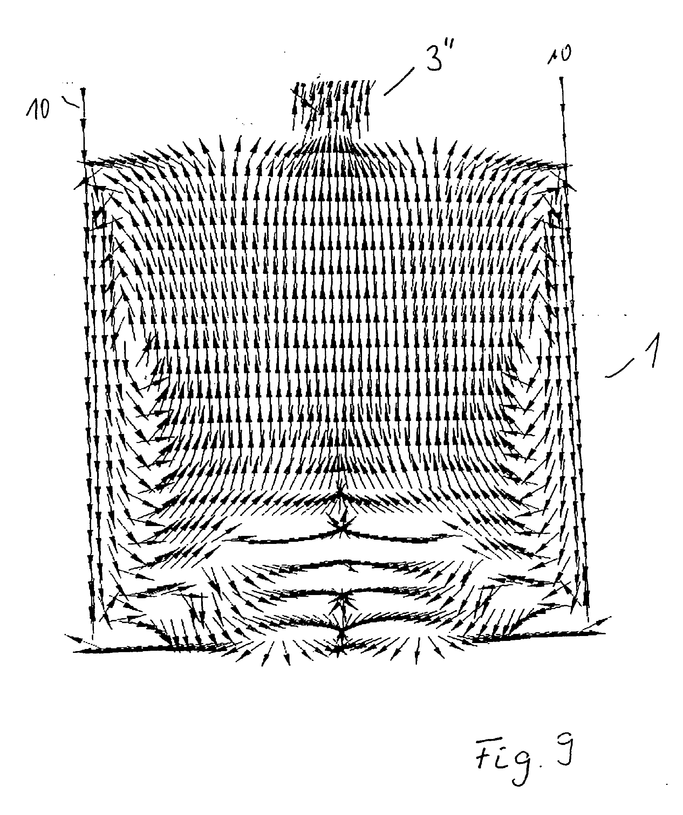

In Figur 9 ist ein Strömungsmodell in einer Ebene durch eine Mikrowellenplasmaquelle 1 dargestellt.

Dabei wird der erste Gasstrom 10 von der Stirnfläche, aus der das Plasma 12 aus der Mikrowellenplasmaquelle 1 ausgetrieben wird, entlang der inneren Mantelfläche der Mikrowellenplasmaquelle 1 in diese eingeführt, an der gegenüberliegenden inneren Stirnfläche umgelenkt und das im Zentrum der Mikrowellenplasmaquelle 1 erzeugte Plasma 2 über in diesem Falle nur eine Düsenöffnung 3" aus der Mikrowellenplasmaquelle 1 in die hier nicht dargestellte Reaktionskammer 5 ausgetrieben.

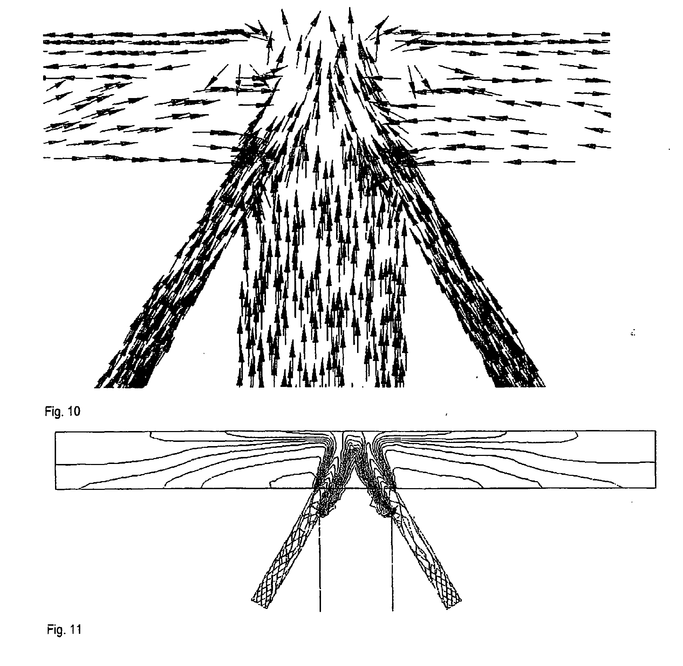

In Figur 10 ist ein durch Computersimulation ermitteltes Strömungsprofil für aus einer Düse 3 mittig ausgetriebenes Plasma in eine Reaktionskammer 5, die einseitig von einem hier nicht dargestellten Substrat 4 begrenzt ist, gezeigt.

Von mindestens zwei gegenüberliegenden Seiten wird in dieses Plasma ein zweiter Gasstrom 6, der mindestens einen Precursor enthält, in den Einflussbereich des Plasmas und dementsprechend auch in die Reaktionskammer 5 zugeführt, so dass auf der Oberfläche des Substrates 4 eine Beschichtung ausgebildet werden kann. Deutlich erkennbar ist die für eine hohe Beschichtungsleistung vorteilhafte hohe Gasgeschwindigkeit der vermischten beiden Gasströme und deren Ausrichtung zur Substratoberfläche.

Selbstverständlich besteht auch die Möglichkeit, den zweiten Gasstrom 6 ringförmig um das durch die Düse 3 in die Reaktionskammer 5 geführte Plasma zuzuführen.

Fig. 11 zeigt beispielhaft die Verteilung der Precursorkonzentration über den in Fig.2 und Fig. 3 dargestellten vorteilhaften Düsenanordnungen. Erkennbar ist die schnelle und gleichmäßige Vermischung des ersten mit dem zweiten Gasstroms in unmittelbarer Nähe der zu beschichtenden Substratoberfläche.

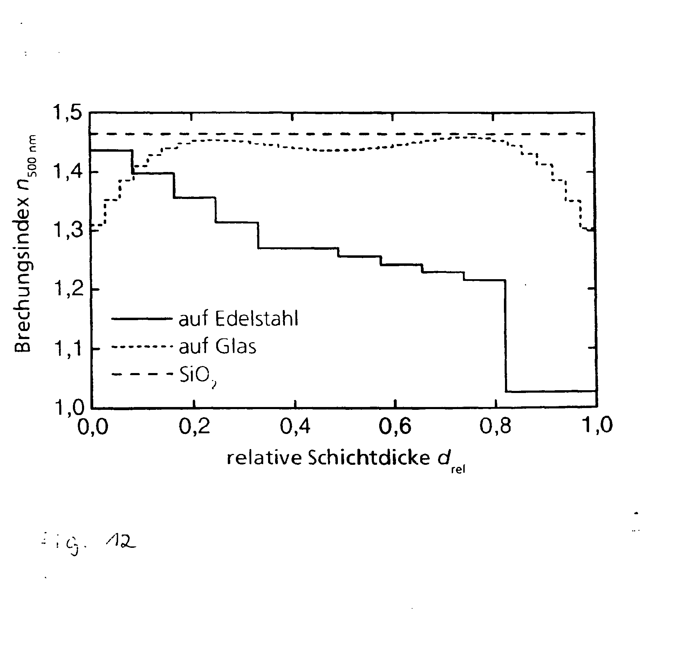

In Fig.12 ist das ellipsometrisch bestimmte Brechungsindexprofil einer SiO2 Schicht auf Glas- und Edelstahl- Substraten beispielhaft dargestellt. In Abhängigkeit von Schichtdicke, den Beschichtungsparametern und dem Substratmaterial weisen die Schichten ein homogenes Tiefenprofil oder einen mehr oder weniger ausgeprägten Dichtegradienten auf. Derartige Schichten können vorteilhaft als haftvermittelnde Zwischenschichten oder zur Erzielung spezieller optischer Eigenschaften eingesetzt werden.

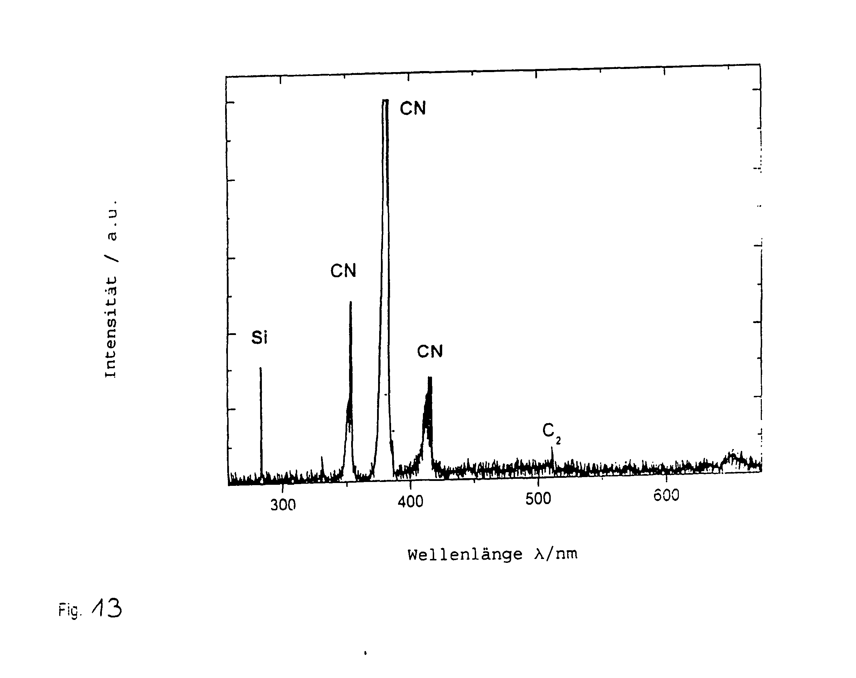

Zur Charakterisierung des aus der Mikrowellen-Plasmakammer ausgetriebenen Plasmas ist in Fig. 13 beispielhaft ein nach Zumischen eines Precursors zur Abscheidung siliziumoxidhaltiger Schichten (Tetraäthoxysilan, TEOS) in Substratnähe gemessenes optisches Emissionspektrum (OES) dargestellt. Erkennbar ist die Fragmentierung des im zweiten Gasstrom enthaltenen Precursors nach Vermischung mit den im ersten Gastrom enthaltenen hochenergetischen Plasmabestandteilen unter Bildung von Silizium-Atomen, die als reaktive Intermediate zur Schichtbildung dienen. Der im Precursor ursprünglich gebundene Kohlenstoff wird vorteilhaft über gasförmige Spezies eluiert und beeinflusst damit nicht die Reinheit der sich bildenden stöchiometrischen SiO₂-Schicht.

## Patentansprüche

1. Verfahren zur großflächigen Beschichtung von Substraten bei Atmosphärendruckbedingungen, bei dem
in eine Plasmaquelle (1, 1') ein erster Gasstrom (10) geführt wird, der Plasma aus einem großvolumigen Plasma (2) aus der Plasmaquelle (1, 1') austreibt und das erzeugte Plasma durch mindestens eine Schlitzdüse (3') oder eine Mehrzahl von Düsen (3) mit anderen Querschnittsgeometrien auf eine zu beschichtende Oberfläche des Substrates (4), die innerhalb einer abgedichteten Reaktionskammer (5) angeordnet ist, gerichtet wird;
die Schichtausbildung unmittelbar auf der Oberfläche des Substrates (4) durch physiko-chemische Reaktion mindestens einer Komponente eines Precursors, als Bestandteil mindestens eines zweiten Gasstromes (6) in die Reaktionskammer (5) und in den Einflussbereich des aus der einen oder mehreren Düsen (3, 3') austretenden Plasmas (12) gerichtet wird,
wobei durch Einstellung der Volumenströme, der Strömungsgeschwindigkeiten und/oder der Strömungsrichtungen des Plasmas (12) und des zweiten Gasstromes (6) sowie
des Abstandes der Düsenöffnung(en) (3") für das Plasma und eines vorgebbaren Innendrucks in der Reaktionskammer (5), mittels einer Abgasabsaugung (7),
die physiko-chemische Reaktion zur Ausbildung der Beschichtung unmittelbar an der Oberfläche des Substrates (4) erfolgt.

2. Verfahren nach Anspruch 1,
**dadurch gekennzeichnet, dass** das Substrat (4) innerhalb der Reaktionskammer (5) bewegt wird.

3. Verfahren nach Anspruch 1 oder 2,
**dadurch gekennzeichnet, dass** das Substrat (4) translatorisch durch die Reaktionskammer (5) bewegt und die Reaktionskammer (5) durch Zufuhr eines Spülgases (8') durch ein Atmosphärendruckschleusensystem (8) am Ein- und Austritt für das Substrat (4) gegen die Umgebung abgedichtet wird.

4. Verfahren nach mindestens einem der Ansprüche 1 bis 3, **dadurch gekennzeichnet, dass** eine Mikrowellenplasmaquelle (1) verwendet wird.

5. Verfahren nach mindestens einem der Ansprüche 1 bis 3, **dadurch gekennzeichnet, dass** in der Plasmaquelle (1') das Plasma mittels eines kontinuierlichen zwischen zwei Elektroden (13) ausgebildeten Lichtbogens erzeugt wird.

6. Verfahren nach mindestens einem der vorhergehenden Ansprüche, **dadurch gekennzeichnet, dass** der Anteil eines Precursors im zweiten Gasstrom (6) maximal 20 Vol.-% beträgt.

7. Verfahren nach mindestens einem der vorhergehenden Ansprüche, **dadurch gekennzeichnet, dass** im zweiten Gasstrom (6) als Precursoren Kohlenwasserstoffverbindungen, metallorganische Verbindungen, siliciumorganische Verbindungen oder Halogenide von Ti, Zr, Ta, Cr, Mo, W, B, Al, Si, Ge, Sn oder Hydride von Si, Ge oder B eingesetzt werden.

8. Verfahren nach mindestens einem der vorhergehenden Ansprüche, **dadurch gekennzeichnet, dass** der zweite Gasstrom (6) in schräg geneigtem Winkel aus Düsen (9), die benachbart zu/zur Düsenöffnung (en) (3") für das Plasma (12) auf die zu beschichtende Oberfläche des Substrates (4) gerichtet wird.

9. Verfahren nach mindestens einem der vorhergehenden Ansprüche, **dadurch gekennzeichnet, dass** zwei benachbarte Düsen (3) für Plasma, das Plasma (12) in einem schräg aufeinander zu gerichteten Winkel in Richtung auf die zu beschichtende Oberfläche des Substrates (4) richten und der zweite Gasstrom (6) durch mindestens eine zwischen den Düsenöffnungen (3") für das Plasma (12) angeordnete Düse (9) in die sich schneidenden Plasmastrahlen (12') zugeführt wird.

10. Verfahren nach mindestens einem der vorhergehenden Ansprüche, **dadurch gekennzeichnet, dass** der zweite Gasstrom (6) mit höherer Strömungsgeschwindigkeit, als das Plasma (12) in den Reaktionsraum (5) geführt wird.

11. Verfahren nach mindestens einem der vorhergehenden Ansprüche, **dadurch gekennzeichnet, dass** bei einer Mikrowellenplasmaquelle (1) der erste Gasstrom (10) entgegengesetzt zur Strömungsrichtung des aus der Plasmaquelle (1) austretenden Plasmas (12), dieses an den äußeren Seiten umschließend in die Plasmaquelle (1) eingeführt wird.

12. Verfahren nach mindestens einem der vorhergehenden Ansprüche, **dadurch gekennzeichnet, dass** für eine Oberflächenmodifizierung Oberflächenreinigung der zu beschichtenden Oberfläche des Substrates (4), die Oberfläche einer thermischen, strahlungsinduzierten und/oder chemischen Beeinflussung unterzogen wird, indem vom zweiten Gasstrom (6) unbeeinflusstes Plasma aus mindestens einer Düsenöffnung (3") auf die Oberfläche des Substrates (4) gerichtet wird.

13. Verfahren nach mindestens einem der vorhergehenden Ansprüche, **dadurch gekennzeichnet, dass** unterschiedliche Abstände zwischen der/den Düsenöffnung(en) (3") für das Plasma (12) und/oder der Düsen (9) für den zweiten Gasstrom (6) und der zu beschichtenden Oberfläche des Substrates (4) eingestellt werden.

14. Verfahren nach mindestens einem der vorhergehenden Ansprüche, **dadurch gekennzeichnet, dass** die Beschichtung durch chemische Reaktion eines Precursorbestandteiles und eines Elementes, das in elementarer Form oder in Form einer chemischen Verbindung Bestandteil des Plasmas und/oder des zweiten und/oder mindestens eines weiteren_Gasstromes ist, gebildet wird.

15. Verfahren nach mindestens einem der vorhergehenden Ansprüche, **dadurch gekennzeichnet, dass** mindestens ein dritter Gasstrom, der mindestens eine weitere Komponente eines Precursors enthält, in den Einflussbereich von aus Düsen (3) für Plasma (12) auf die zu beschichtende Oberfläche eines Substrates (4) gerichteten Plasma zugeführt wird.

16. Verfahren nach mindestens einem der vorhergehenden Ansprüche, **dadurch gekennzeichnet, dass** Absaugmittel (7') der Abgasabsaugung (7) in Abhängigkeit des Innendruckes in der Reaktionskammer (5) geregelt oder gesteuert werden.

17. Verfahren nach mindestens einem der vorhergehenden Ansprüche, **dadurch gekennzeichnet, dass** sämtliche Komponenten innerhalb der Reaktionskammer (5) in Gasphasenform vorliegen und lediglich die, die Beschichtung bildende(n) Komponente(n) unmittelbar auf der zu beschichtenden Oberfläche des Substrates (4) in eine feste Phase überführt werden.

18. Vorrichtung zur großflächigen Beschichtung von Substraten bei Atmosphärenbedingungen mit einer
ein großvolumiges Plasma (2) erzeugenden Plasmaquelle (1, 1') die über mindestens eine Düse (3, 3') für den Austrieb von Plasma (12) mittels eines ersten Gasstromes (10) in Richtung auf eine zu beschichtende Oberfläche eines Substrates (4) mit einer Reaktionskammer (5) verbunden ist;
mindestens einer weiteren Düse (9) für die Zufuhr mindestens eines zweiten Gasstromes (6), in dem mindestens ein schichtbildender Precursor enthalten ist, in den Einflussbereich des aus der Plasmaquelle (1, 1') in die gegenüber der Umgebung abgedichtete Reaktionskammer (5) ausgetriebenen Plasmas (12) sowie
Mitteln zur Beeinflussung der Strömungsgeschwindigkeiten, der Volumenströme des ersten und zweiten Gasstromes (6), der Strömungsrichtung des in die Reaktionskammer (5) geführten Plasmas (12) und des zweiten Gasstromes (6) und/oder
des Abstandes zwischen zu beschichtender Oberfläche des Substrates (4) und Düsenöffnungen (3'') für Plasma (12) und zweitem Gasstrom (6) und Mitteln (7, 7') zur Regelung oder Steuerung des Innendruckes innerhalb der Reaktionskammer (5), so dass die Schichtausbildung und die physiko-chemische Reaktion zur Ausbildung der Beschichtung unmittelbar an der Oberfläche des Substrates (4) erfolgen.

19. Vorrichtung nach Anspruch 18, **dadurch gekennzeichnet, dass** die Plasmaquelle (1) eine Mikrowellenplasmaquelle mit zylinderförmiger Plasmakammer (1.1) ist, wobei der erste Gasstrom (10) in die Plasmakammer (1.1) über eine Ringdüse oder eine kreisförmige Anordnung von Düsen parallel zu und entlang der inneren Zylindermantelfläche geführt ist und die mindestens eine Düse (3) in der, der Reaktionskammer (5) zugewandten Stirnfläche der Plasmaquelle (1) angeordnet ist.

20. Vorrichtung nach Anspruch 19, **dadurch gekennzeichnet, dass** die Ringdüse oder die kreisförmige Anordnung von Düsen die mindestens eine Düse (3) für den Austritt von Plasma (12) an der gleichen Stirnseite der Plasmaquelle (1) angeordnet sind.

21. Vorrichtung nach Anspruch 19 oder 20, **dadurch gekennzeichnet, dass** mindestens zwei Reihen von Düsen (3) für den Austritt von Plasma (21) vorhanden sind.

22. Vorrichtung nach Anspruch 21, **dadurch gekennzeichnet, dass** die Reihen parallel zueinander ausgerichtet und die Düsen (3) in benachbarten Reihen versetzt zueinander angeordnet sind.

23. Vorrichtung nach Anspruch 18, **dadurch gekennzeichnet, dass** die Plasmaquelle (1') mindestens zwei zueinander beabstandete Elektroden (13) aufweist, zwischen denen mittels eines Lichtbogens ein lang gestrecktes großvolumiges Plasma ausgebildet ist und die mindestens eine Düse (3') für den Austritt von Plasma (12) als Schlitzdüse ausgebildet ist.

24. Vorrichtung nach mindestens einem der Ansprüche 18 bis 23, **dadurch gekennzeichnet, dass** einer oder mehreren Düsen (3, 3') für den Austritt von Plasma (12) mindestens eine Düse (9) für die Zufuhr des zweiten Gasstromes (6) in den Einflussbereich des ausgetriebenen Plasmas (12) zugeordnet ist.

25. Vorrichtung nach Anspruch 24, **dadurch gekennzeichnet, dass** die Düse(n) (6), als eine jeweils eine Düse (3, 3') umschließende Ringdüse ausgebildet ist/sind.

26. Vorrichtung nach Anspruch 23, **dadurch gekennzeichnet, dass** die Schlitzdüse(n) (3") mit einer Loch- oder Schlitzblende abgedeckt ist/sind.

27. Vorrichtung nach mindestens einem der Ansprüche 18 bis 26, **dadurch gekennzeichnet, dass** mindestens zwei Düsen (3, 3') in einem Winkel aufeinander zu, schräg geneigt sind und zwischen diesen Düsen (3, 3') mindestens eine Düse (9) für den zweiten Gasstrom (6) angeordnet ist.

28. Vorrichtung nach mindestens einem der Ansprüche 18 bis 27, **dadurch gekennzeichnet, dass** die Abgasabsaugung (7), die Reaktionskammer (5) allseitig umschließt.

29. Vorrichtung nach mindestens einem der Ansprüche 18 bis 28, **dadurch gekennzeichnet, dass** mindestens eine Spülgaszuführung ein Atmosphärendruckschleusensystem (8) für die Reaktionskammer (5) bildet.

## Claims

1. A method for the large-area coating of substrates under atmospheric pressure conditions, in which
a first gas stream (10) is passed into a plasma source (1, 1'), which stream expels plasma from a large-volume plasma (2) from the plasma source (1, 1'), and the plasma produced is directed through at least one slotted nozzle (3') or a plurality of nozzles (3) with different cross-sectional geometries on to a surface which is to be coated of the substrate (4), which surface is located within a sealed-off reaction chamber (5);
the layer formation takes place directly on the surface of the substrate (4) by physico-chemical reaction of at least one component of a precursor, as a constituent of at least one second gas stream (6) which is directed into the reaction chamber (5) and into the region of influence of the plasma (12) emerging from the one or more nozzles (3, 3'),
with, by adjusting the volume flows, the flow rates and/or the directions of flow of the plasma (12) and of the second gas stream (6) and also
the distance between the nozzle opening(s) (3") for the plasma and a pre-settable internal pressure in the reaction chamber (5), by means of an exhaust extraction device (7),
the physico-chemical reaction for forming the coating taking place directly on the surface of the substrate (4).

2. A method according to Claim 1, **characterised in that** the substrate (4) is moved within the reaction chamber (5).

3. A method according to Claim 1 or 2, **characterised in that** the substrate (4) is moved in translational through the reaction chamber (5) and the reaction chamber (5) is sealed off from its surroundings by supplying a flushing gas (8') through an atmospheric pressure lock system (8) at the entry and exit for the substrate (4).

4. A method according to at least one of Claims 1 to 3, **characterised in that** a microwave plasma source (1) is used.

5. A method according to at least one of Claims 1 to 3, **characterised in that** the plasma is generated in the plasma source (1') by means of a continuous arc formed between two electrodes (13).

6. A method according to at least one of the preceding claims, **characterised in that** the proportion of a precursor in the second gas stream (6) is at most 20% by volume.

7. A method according to at least one of the preceding claims, **characterised in that** hydrocarbon compounds, organometallic compounds, silicon-organic compounds or halides of Ti, Zr, Ta, Cr, Mo, W, B, Al, Si, Ge, Sn or hydrides of Si, Ge or B are used in the second gas stream (6) as precursors.

8. A method according to at least one of the preceding claims, **characterised in that** the second gas stream (6) is directed on to the surface which is to be coated of the substrate (4) at an obliquely inclined angle from nozzles (9) which are adjacent to nozzle opening(s) (3 ") for the plasma (12).

9. A method according to at least one of the preceding claims, **characterised in that** two adjacent nozzles (3) for plasma direct the plasma (12) at an angle which is directed obliquely towards each other towards the surface which is to be coated of the substrate (4) and the second gas stream (6) is supplied through at least one nozzle (9) arranged between the nozzle openings (3") for the plasma (12) into the intersecting plasma jets (12').

10. A method according to at least one of the preceding claims, **characterised in that** the second gas stream (6) is passed into the reaction space (5) at a higher flow rate than the plasma (12).

11. A method according to at least one of the preceding claims, **characterised in that** in the case of a microwave plasma source (1) the first gas stream (10) is introduced into the plasma source (1) counter to the direction of flow of the plasma (12) emerging from the plasma source (1), surrounding said plasma on the outer sides.

12. A method according to at least one of the preceding claims, **characterised in that** for surface modification, surface cleaning of the surface which is to be coated of the substrate (4), the surface is subjected to thermal, radiation-induced and/or chemical influencing, **in that** plasma which is uninfluenced by the second gas stream (6) is directed on to the surface of the substrate (4) from at least one nozzle opening (3").

13. A method according to at least one of the preceding claims, **characterised in that** different distances are set between the nozzle opening(s) (3") for the plasma (12) and/or the nozzles (9) for the second gas stream (6) and the surface which is to be coated of the substrate (4).

14. A method according to at least one of the preceding claims, **characterised in that** the coating is formed by chemical reaction of a precursor constituent and an element which is in elemental form or in the form of a chemical compound constituent of the plasma and/or of the second and/or at least one further gas stream.

15. A method according to at least one of the preceding claims, **characterised in that** at least one third gas stream, which contains at least one further component of a precursor, is supplied into the region of influence of plasma directed from nozzles (3) for plasma (12) on to the surface which is to be coated of a substrate (4).

16. A method according to at least one of the preceding claims, **characterised in that** extraction means (7') of the exhaust extraction device (7) are regulated or controlled dependent on the internal pressure in the reaction chamber (5).

17. A method according to at least one of the preceding claims, **characterised in that** all the components within the reaction chamber (5) are present in gas phase form and merely the component(s) forming the coating is/are converted into a solid phase directly on the surface which is to be coated of the substrate (4).

18. A device for the large-area coating of substrates under atmospheric conditions, with a
plasma source (1, 1') which generates a large-volume plasma (2), which source is connected to a reaction chamber (5) via at least one nozzle (3, 3') for expelling plasma (12) by means of a first gas stream (10) towards a surface which is to be coated of a substrate (4);
at least one further nozzle (9) for supplying at least a second gas stream (6), in which at least one layer-forming precursor is contained, into the region of influence of the plasma (12) expelled from the plasma source (1, 1') into the reaction chamber (5) which is sealed off from the surroundings, and
means for influencing of the flow rates, the volume flows of the first and second gas stream (6), the direction of flow of the plasma (12) passed into the reaction chamber (5) and the second gas stream (6), and/or
of the distance between the surface which is to be coated of the substrate (4) and nozzle openings (3") for plasma (12) and second gas stream (6) and means (7, 7') for regulating or controlling the internal pressure within the reaction chamber (5), so that the layer formation and the physico-chemical reaction for forming the coating take place directly on the surface of the substrate (4).

19. A device according to Claim 18, **characterised in that** the plasma source (1) is a microwave plasma source with cylindrical plasma chamber (1.1), the first gas stream (10) being passed into the plasma chamber (1.1) via a ring nozzle or a circular arrangement of nozzles parallel to and along the inner cylinder casing surface and the at least one nozzle (3) being arranged in the end face of the plasma source (1) which faces the reaction chamber (5).

20. A device according to Claim 19, **characterised in that** the ring nozzle or the circular arrangement of nozzles the at least one nozzle (3) for the emergence of plasma (12) are arranged on the same end face of the plasma source (1).

21. A device according to Claim 19 or 20, **characterised in that** at least two rows of nozzles (3) for the emergence of plasma (21) are present.

22. A device according to Claim 21, **characterised in that** the rows are oriented parallel to one another and the nozzles (3) are arranged offset relative to one another in adjacent rows.

23. A device according to Claim 18, **characterised in that** the plasma source (1') has at least two electrodes (13) spaced apart from each other, between which an elongate large-volume plasma is formed by means of an arc and the at least one nozzle (3') for the emergence of plasma (12) is designed as a slotted nozzle.

24. A device according to at least one of Claims 18 to 23, **characterised in that** one or more nozzles (3, 3') for the emergence of plasma (12) is/are assigned at least one nozzle (9) for supplying the second gas stream (6) into the region of influence of the expelled plasma (12).

25. A device according to Claim 24, **characterised in that** the nozzle(s) (6) is/are designed as a ring nozzle surrounding a nozzle (3, 3') in each case.

26. A device according to Claim 23, **characterised in that** the slotted nozzle(s) (3") is/are covered with a perforated or slotted diaphragm.

27. A device according to at least one of Claims 18 to 26, **characterised in that** at least two nozzles (3, 3') are inclined obliquely at an angle towards one another, and at least one nozzle (9) for the second gas stream (6) is arranged between these nozzles (3, 3').

28. A device according to at least one of Claims 18 to 27, **characterised in that** the exhaust extraction device (7) surrounds the reaction chamber (5) on all sides.

29. A device according to at least one of Claims 18 to 28, **characterised in that** at least one supply of flushing gas forms an atmospheric pressure lock system (8) for the reaction chamber (5).

## Revendications

1. Procédé pour le revêtement sur de grandes surfaces de substrats dans des conditions de pression atmosphérique, dans lequel
on envoie dans une source de plasma (1, 1') un premier flux de gaz (10), le plasma s'échappe d'un plasma en grand volume (2) de la source de plasma (1, 1') et le plasma engendré est dirigé, par au moins une buse plate (3') ou une multiplicité de buses (3) à autres géométries de section transversale, sur une surface à revêtir du substrat (4), qui est disposée à l'intérieur d'une chambre de réaction étanchéifiée (5) ;
la formation de couches est dirigée directement sur la surface du substrat (4) par réaction physico-chimique d'au moins un composant d'un précurseur, en tant que composant d'au moins un deuxième flux de gaz (6) dans la chambre de réaction (5) et dans la zone d'influence du plasma (12) sortant de la buse ou de plusieurs buses (3, 3'),
dans lequel, par réglage des flux volumiques, des vitesses d'écoulement et/ou des directions de flux du plasma (12) et du deuxième flux de gaz (6) ainsi que
de la distance de l'orifice/des orifices de buse(s) (3") pour le plasma et d'une pression interne pouvant être préétablie dans la chambre de réaction (5), au moyen d'une aspiration de gaz rejeté (7)
la réaction physico-chimique pour la formation du revêtement s'effectue directement sur la surface du substrat (4).

2. Procédé selon la revendication 1, **caractérisé en ce que** le substrat (4) est mis en mouvement à l'intérieur de la chambre de réaction (5).

3. Procédé selon la revendication 1 ou 2, **caractérisé en ce que** le substrat (4) est mû par translation dans la chambre de réaction (5) et la chambre de réaction (5) est étanchéifiée vis-à-vis de l'environnement par apport d'un gaz de lavage (8') à travers un système de sas de décompression sous la pression atmosphérique (8) à l'entrée et à la sortie pour le substrat (4).

4. Procédé selon au moins l'une des revendications 1 à 3, **caractérisé en ce qu'**on utilise une source de plasma (1) à micro-ondes.

5. Procédé selon au moins l'une des revendications 1 à 3, **caractérisé en ce que** le plasma est engendré dans la source de plasma (1') au moyen d'un arc électrique formé en continu entre deux électrodes (13).

6. Procédé selon au moins l'une des revendications précédentes, **caractérisé en ce que** la proportion d'un précurseur dans le deuxième flux de gaz (6) est au maximum de 20 % en volume.

7. Procédé selon au moins l'une des revendications précédentes, **caractérisé en ce qu'**on utilise comme précurseurs dans le deuxième flux de gaz (6) des composés hydrocarbonés, des composés organométalliques, des composés organosiliciés ou des halogénures de Ti, Zr, Ta, Cr, Mo, W, B, Al, Si, Ge, Sn ou des hydrures de Si, Ge ou B.

8. Procédé selon au moins l'une des revendications précédentes, **caractérisé en ce que** le deuxième flux de gaz (6) est dirigé sur la surface à revêtir du substrat (4) en un angle oblique hors des buses (9) qui sont voisines de l'orifice/ des orifices (3") pour le plasma (12).

9. Procédé selon au moins l'une des revendications précédentes, **caractérisé en ce que** deux buses (3) pour plasma voisines dirigent le plasma (12) en un angle à orienter obliquement l'une par rapport à l'autre en direction de la surface à revêtir du substrat (4) et le deuxième flux de gaz (6) est envoyé, par au moins une buse (9) disposée entre les orifices de buses (3") pour le plasma (12), dans les jets de plasma (12') qui se coupent.

10. Procédé selon au moins l'une des revendications précédentes, **caractérisé en ce que** le deuxième flux de gaz (6) est envoyé dans la chambre de réaction (5) à une plus grande vitesse d'écoulement que le plasma (12).

11. Procédé selon au moins l'une des revendications précédentes, **caractérisé en ce que** dans le cas d'une source de plasma à micro-ondes (1), le premier flux de gaz (10) est introduit en un sens opposé au sens d'écoulement du plasma (12) sortant de la source de plasma (1), celui-ci est introduit sur les faces externes qui entourent dans la source de plasma (1).

12. Procédé selon au moins l'une des revendications précédentes, **caractérisé en ce que** pour une modification de la surface, un nettoyage superficiel de la surface à revêtir du substrat (4), on soumet la surface à une influence thermique, induite par un rayonnement et/ou chimique, en dirigeant du plasma non influencé par le deuxième flux de gaz (6), provenant d'au moins un orifice de buse (3") sur la surface du substrat (4).

13. Procédé selon au moins l'une des revendications précédentes, **caractérisé en ce que** des distances différentes sont ajustées entre le(s) orifice(s) de buse(s) (3") pour le plasma (12) et/ou les buses (9) pour le deuxième flux de gaz (6) et la surface à revêtir du substrat (4).

14. Procédé selon au moins l'une des revendications précédentes, **caractérisé en ce que** le revêtement est formé par réaction chimique d'un composant précurseur et d'un élément qui est sous forme élémentaire ou sous forme d'un composé chimique composant du plasma et/ou du deuxième et/ou d'au moins un autre flux de gaz.

15. Procédé selon au moins l'une des revendications précédentes, **caractérisé en ce qu'**au moins un troisième flux de gaz, qui contient au moins un autre composant d'un précurseur, est envoyé dans la zone d'influence du plasma dirigé, hors des buses (3) pour plasma (12), sur la surface à revêtir d'un substrat (4).

16. Procédé selon au moins l'une des revendications précédentes, **caractérisé en ce que** le moyen d'aspiration (7') de l'aspiration de gaz rejeté (7) est commandé ou réglé en fonction de la pression interne dans la chambre de réaction (5).

17. Procédé selon au moins l'une des revendications précédentes, **caractérisé en ce que** tous les composants à l'intérieur de la chambre de réaction (5) se trouvent sous forme de phase gazeuse et seulement le(s) composant(s) formant le revêtement est/sont transformé(s) en une phase solide directement sur la surface à revêtir du substrat (4).

18. Dispositif pour le revêtement sur de grandes surfaces de substrats dans des conditions de pression atmosphérique, comportant
une source de plasma (1, 1'), engendrant un plasma (2) en grand volume, qui est raccordée à une chambre de réaction (5) par au moins une buse (3, 3') pour l'expulsion du plasma (12) au moyen d'un premier flux de gaz (10) en direction d'une surface à revêtir d'un substrat (4) ;
au moins une autre buse (9) pour l'apport d'au moins un deuxième flux de gaz (6), dans lequel est contenu au moins un précurseur générateur de couche, dans la zone d'influence du plasma (12) expulsé de la source de plasma (1, 1') dans la chambre de réaction (5) étanchéifiée vis-à-vis de l'environnement, ainsi que
des moyens destinés à influer sur les vitesses d'écoulement, les débits volumiques des premier et deuxième flux de gaz (6), la direction d'écoulement du plasma (12) envoyé dans la chambre de réaction (5) et du deuxième flux de gaz (6) et/ou
de la distance entre la surface à revêtir du substrat (4) et les orifices des buses (3") pour plasma (12) et deuxième flux de gaz (6) et des moyens (7, 7') pour la commande ou le réglage de la pression interne à l'intérieur de la chambre de réaction (5), de sorte que la formation de couche et la réaction physico-chimique pour la formation du revêtement s'effectuent directement sur la surface du substrat (4).

19. Dispositif selon la revendication 18, **caractérisé en ce que** la source de plasma (1) est une source de plasma à micro-ondes comportant une chambre cylindrique à plasma (1.1), le premier flux de gaz (10) étant envoyé dans la chambre à plasma (1.1) par une buse annulaire ou un ensemble circulaire de buses parallèle à et le long de la surface de l'enveloppe cylindrique interne, et ladite au moins une buse (3) dans laquelle est disposée la face frontale de la source de plasma (1) qui est tournée vers la chambre de réaction (5).

20. Dispositif selon la revendication 19, **caractérisé en ce que** la buse annulaire ou l'ensemble circulaire de buse et ladite au moins une buse (3) pour la sortie du plasma (12) sont disposées au niveau de la même face frontale de la source de plasma (1).

21. Dispositif selon la revendication 19 ou 20, **caractérisé en ce qu'**au moins deux rangées de buses (3) sont présentes pour la sortie du plasma (21).

22. Dispositif selon la revendication 21, **caractérisé en ce que** les rangées sont orientées parallèlement entre elles et les buses (3) sont disposées en étant décalées les unes par rapport aux autres dans des rangées contiguës.

23. Dispositif selon la revendication 18, **caractérisé en ce que** la source de plasma (1') comporte au moins deux électrodes (13) distantes l'une de l'autre, entre lesquelles est engendré au moyen d'un arc électrique un plasma en grand volume s'étendant en longueur et ladite au moins une buse (3') est en forme de buse plate pour la sortie du plasma (12).

24. Dispositif selon au moins l'une des revendications 18 à 23, **caractérisé en ce qu'**à une ou plusieurs buses (3, 3') pour la sortie du plasma (12) est affectée au moins une buse (9) pour l'apport du deuxième flux de gaz (6) dans la zone d'influence du plasma (12) expulsé.

25. Dispositif selon la revendication 24, **caractérisé en ce que** la/les buse(s) (6) est/sont constituée(s) chacune sous forme d'une buse annulaire entourant chaque fois une buse (3, 3').

26. Dispositif selon la revendication 23, **caractérisé en ce que** la/les buse(s) plate(s) (3") est/sont couvertes d'un diaphragme à trou ou à fente.

27. Dispositif selon au moins l'une des revendications 18 à 26, **caractérisé en ce qu'**au moins deux buses (3, 3') sont inclinées en un angle l'une par rapport à l'autre, et entre ces buses (3, 3') est disposée au moins une buse (9) pour le deuxième flux de gaz (6).

28. Dispositif selon au moins l'une des revendications 18 à 27, **caractérisé en ce que** l'aspiration de gaz rejeté (7) entoure de tous côtés la chambre de réaction (5).

29. Dispositif selon au moins l'une des revendications 18 à 28, **caractérisé en ce qu'**au moins une alimentation en gaz de lavage forme un système de sas (8) sous la pression atmosphérique pour la chambre de réaction (5).
